(19) Europäisches Patentamt
European Patent Office
Office européen des brevets

(11)　EP 2 779 221 A1

(12)　DEMANDE DE BREVET EUROPEEN

(43) Date de publication:
**17.09.2014 Bulletin 2014/38**

(51) Int Cl.:
***H01L 21/66*** *(2006.01)*

(21) Numéro de dépôt: **14159954.8**

(22) Date de dépôt: **14.03.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **15.03.2013 FR 1352306**

(71) Demandeurs:
- **Commissariat à l'Énergie Atomique et aux Énergies Alternatives
75015 Paris (FR)**
- **Centre National de la Recherche Scientifique
75794 Paris Cedex 16 (FR)**
- **Université Montpellier 2, Sciences et Techniques
34090 Montpellier (FR)**

(72) Inventeurs:
- **FKIH, Yassine
38100 Grenoble (FR)**
- **VIVET, Pascal
38760 Saint Paul de Varces (FR)**
- **ROUZEYRE, Bruno
34080 Montpellier (FR)**
- **FLOTTES, Marie-Lise
34680 Saint Georges d'Orques (FR)**
- **DI NATALE, Giorgio
34380 Mas de Londres (FR)**

(74) Mandataire: **Bonnet, Michel
Cabinet Bonnet
93, Rue Réaumur - Boîte 10
75002 Paris (FR)**

(54)　**Procédé, dispositif et système de détection automatique de défauts dans des vias TSV**

(57)　Ce procédé de détection automatique de défauts dans des vias TSV formés dans une couche de matériau semi-conducteur, cette détection ayant lieu avant empilement de cette couche avec une pluralité d'autres couches de matériau semi-conducteur lors de la conception d'un circuit intégré sur puce à couches multiples, comporte :
- la mesure (100) sur chacun desdits vias TSV d'au moins un paramètre ($F_1$, $F_2$, ..., $F_J$) issu d'une caractéristique électrique des vias TSV,
- la détection (110) de défauts dans lesdits vias TSV en fonction d'une comparaison des paramètres mesurés ($F_1$, $F_2$, ..., $F_J$) avec au moins un paramètre de référence ($F_{REF}$ ; $F_{REF-INF}$, $F_{REF-SUP}$),
- le calcul dudit au moins un paramètre de référence ($F_{REF}$ ; $F_{REF-INF}$, $F_{REF-SUP}$) à partir des paramètres mesurés ($F_1$, $F_2$, ..., $F_J$).

Le paramètre ($F_1$, $F_2$, ..., $F_J$) mesuré sur chacun des vias TSV (14) comporte une valeur de fréquence d'oscillation issue d'une caractéristique capacitive des vias TSV (14).

*Figure 6*

EP 2 779 221 A1

**Description**

La présente invention concerne un procédé de détection automatique de défauts dans des vias TSV. Elle concerne également un dispositif et un système de détection mettant en oeuvre ce procédé.

L'invention s'applique plus particulièrement à un procédé de détection automatique de défauts dans des vias TSV formés dans une couche de matériau semi-conducteur, cette détection ayant lieu avant empilement de cette couche avec une pluralité d'autres couches de matériau semi-conducteur lors de la conception d'un circuit intégré sur puce à couches multiples, comportant :

- la mesure sur chacun desdits vias TSV d'au moins un paramètre issu d'une caractéristique électrique des vias TSV,
- la détection de défauts dans lesdits vias TSV en fonction d'une comparaison des paramètres mesurés avec au moins un paramètre de référence.

Afin de répondre aux performances et à la diversification des fonctionnalités exigées dans les nouveaux dispositifs électroniques, la miniaturisation ainsi que le regroupement de composants électroniques de technologies de natures différentes sur une même puce s'avèrent nécessaires. La densité des réseaux d'interconnexions sur une même puce est de cette façon augmentée engendrant des effets non souhaités, comme l'amplification des effets parasites, l'augmentation des délais d'interconnexion entre composants et l'augmentation de la dissipation d'énergie, réduisant les performances du dispositif électronique final. L'empilement de couches de matériau semi-conducteur de natures différentes interconnectées électriquement à l'aide de connexions verticales traversant ces couches permet de résoudre une partie des problèmes précédemment évoqués. Ce type de connexion verticale traversant les couches est appelé via TSV (de l'anglais, « Through Silicon Via »).

Afin de valider la fiabilité des circuits intégrés sur puce à couches multiples, des tests de fiabilité sont réalisés sur chaque couche de matériau semi-conducteur du circuit et en particulier sur les vias TSV qui vont assurer l'interconnexion électrique entre ces couches. En outre, les tests sur les vias TSV sont effectués à chaque étape de fabrication du circuit.

La détection de défauts sur les vias TSV dans les premières étapes de fabrication du circuit avant empilement des couches facilite la localisation et la réparation de défauts de ces vias TSV. Néanmoins, le test des vias TSV avant empilement présente des contraintes. Notamment, l'utilisation de pointes de testeurs afin d'établir un contact direct avec les vias TSV est technologiquement difficile, car les diamètres des vias TSV, de l'ordre de 5 $\mu$m, sont plus petits que les diamètres des pointes de testeurs usuelles, de l'ordre de 35 $\mu$m. En outre, la pression mécanique exercée par les pointes de testeurs sur les vias TSV doit être maîtrisée afin d'éviter d'endommager les vias TSV. Enfin, avant l'étape d'amincissement de la couche de matériau semi-conducteur, l'accès aux deux extrémités d'un via TSV n'est pas possible, car la profondeur d'un via TSV est généralement d'environ 80 $\mu$m alors que la couche de matériau semi-conducteur présente une épaisseur d'environ 750 $\mu$m avant amincissement, limitant ainsi les types de tests pouvant être utilisés.

En pratique, des solutions dites de test indirect sont utilisées. Ces solutions ajoutent au circuit intégré, dès sa conception, une architecture de test permettant de mesurer certaines caractéristiques électriques sur chacun des vias TSV formés dans la couche de matériau semi-conducteur et de détecter automatiquement certains défauts dans ces vias TSV.

Lors de la formation de certains vias TSV, deux types majeurs de défauts de fabrication provoquant la modification des caractéristiques électriques des vias TSV peuvent être détectés :

- « défauts du conducteur » : un mauvais remplissage d'un via TSV ou la présence de microvides dans le via TSV engendrent l'apparition de cavités dans le via TSV provoquant une variation de sa capacité et de sa résistance,
- « défauts de l'isolant » : un mauvais dépôt de la couche d'isolant autour d'un via TSV ou des poussières déposées lors de la fabrication du via TSV peuvent engendrer une connexion résistive entre le via TSV et la couche de matériau semi-conducteur dans laquelle il est formé, provoquant des courants de fuites à travers ce via TSV.

Plusieurs architectures de test de vias TSV ont été proposées ces dernières années. L'article de Chen et al, intitulé « On-chip TSV testing for 3D IC before bonding using sense amplification », publié dans Asian Test Symposium (ATS), pages 450-455, 2009, propose l'utilisation d'amplificateurs de détection. Un inverseur est connecté à un via TSV et permet ainsi de charger le via TSV à travers le transistor PMOS de l'inverseur à la tension d'alimentation $V_{DD}$ et de décharger le via TSV à travers la résistance d'un transistor NMOS. Le temps de décharge du via TSV est mesuré et comparé par un amplificateur de détection à un temps de référence préétabli, cet amplificateur comportant deux inverseurs connectés en série. Les transistors des amplificateurs sont dimensionnés préalablement avec des tensions de seuil permettant de déterminer l'intervalle de temps de décharge des vias TSV sans défauts et générant un signal de sortie sur 1 bit. Néanmoins, ce schéma présente des limitations. D'une part, la résolution et la précision de cette solution sont limitées par le temps de décharge minimal que l'amplificateur de détection peut détecter. En effet, si le temps de décharge est trop rapide, l'amplificateur peut ne pas le détecter correctement. D'autre part, les valeurs des tensions de seuil de référence permettant d'identifier les vias TSV sans défauts sont fixées lors de la conception du circuit et les variations possibles des capacités des vias TSV et des tensions de seuil des transistors lors de la fabrication du circuit doivent être considérées lors du choix de l'intervalle de temps de décharge des vias TSV sans défauts.

L'article de Lou et al, intitulé « Comparing Through-Silicon-Via (TSV) void/pinhole defect self-test methods », publié dans Journal of Electronic Testing, Volume 28, Issue 1, pages 27-38, novembre 2011, décrit et compare trois méthodes de détection automatique de défauts dans des vias TSV. La première méthode correspond à celle décrite précédemment et utilise des amplificateurs de détection pour mesurer la variation du temps de décharge des vias TSV permettant de détecter certains défauts du conducteur et dans certains cas des courants de fuites à travers l'isolant. La deuxième méthode permet de détecter les défauts de l'isolant en mesurant le courant de fuites et en le comparant à une valeur de référence moyennant un comparateur. Cette méthode utilise la même approche que la méthode précédente, mais remplace le transistor NMOS par une résistance de valeur préétablie. La troisième méthode permet de détecter certains défauts du conducteur en comparant la capacité du via TSV à une capacité de référence intégrée dans le circuit, la valeur de cette capacité correspondant à la valeur attendue de la capacité estimée d'un via TSV sans défauts. Les désavantages de cette dernière méthode par rapport aux deux autres sont la surface et la consommation élevées du circuit de test utilisé pour effectuer les mesures ainsi que le besoin de concevoir des capacités de référence de l'ordre du femto farad. Dans les trois cas précédemment décrits, la sortie du circuit de test est connectée à une chaîne de numérisation comportant des multiplexeurs et des mémoires à bascule et générant en sortie un bit de réussite/échec pour chacun des vias TSV analysés.

Toutes les méthodes de détection de défauts dans les vias TSV précédemment décrites comparent les paramètres mesurés à des paramètres préétablis fixés lors de la conception du circuit, par exemple le temps de décharge, la résistance ou la capacité d'un via TSV sans défauts. La précision des tests ainsi effectués peut être compromise par les variations possibles des valeurs de ces paramètres préétablis lors du procédé de fabrication du circuit.

Il peut ainsi être souhaité de prévoir un procédé de détection automatique de défauts dans des vias TSV qui permette de s'affranchir d'au moins une partie des problèmes et contraintes précités.

L'invention a donc pour objet un procédé de détection automatique de défauts dans des vias TSV formés dans une couche de matériau semi-conducteur, cette détection ayant lieu avant empilement de cette couche avec une pluralité d'autres couches de matériau semi-conducteur lors de la conception d'un circuit intégré sur puce à couches multiples, comportant :

- la mesure sur chacun desdits vias TSV d'au moins un paramètre issu d'une caractéristique électrique des vias TSV,
- la détection de défauts dans lesdits vias TSV en fonction d'une comparaison des paramètres mesurés avec au moins un paramètre de référence,

comportant en outre une étape de calcul dudit au moins un paramètre de référence à partir des paramètres mesurés.

Ainsi, grâce à l'invention, le ou les paramètres de référence ne sont pas fixés de façon absolue lors de la conception du circuit, mais calculés de façon relative à partir des paramètres mesurés eux-mêmes lors des tests de fiabilité du circuit. Ces paramètres pouvant être calculés à chaque étape du procédé de fabrication du circuit lorsque les mesures sont réalisées, le test n'est pas altéré par une variation possible des valeurs des caractéristiques électriques des vias TSV et des transistors ayant lieu lors des différentes étapes du procédé de fabrication du circuit. C'est particulièrement vrai lorsque certains paramètres de fabrication, par exemple la température ou la tension d'alimentation, peuvent globalement varier et donc affecter les paramètres mesurés.

De façon avantageuse, ledit au moins un paramètre mesuré sur chacun des vias TSV comporte une valeur de fréquence d'oscillation issue d'une caractéristique capacitive des vias TSV.

De façon optionnelle, le calcul dudit au moins un paramètre de référence comporte :

- la détermination, à partir des paramètres mesurés, d'une valeur attendue du paramètre à mesurer sur chacun desdits vias TSV, cette valeur attendue étant considérée comme caractéristique d'un via TSV sans défaut, et
- le calcul dudit au moins un paramètre de référence par application d'un paramètre d'écart permis, prédéterminé et programmable, autour de cette valeur attendue.

De façon optionnelle également, la mesure sur chacun desdits vias TSV d'une valeur de fréquence d'oscillation issue d'une caractéristique capacitive des vias TSV comporte les étapes suivantes:

- connexion d'un ensemble d'oscillateurs en anneau à tous les vias TSV formés dans la couche de matériau semi-conducteur, chaque oscillateur en anneau étant connecté à au moins un via TSV,
- sélection séquentielle de chacun desdits oscillateurs en anneau,
- mesure séquentielle d'une fréquence d'oscillation de chaque oscillateur en anneau sélectionné.

De façon optionnelle également :

- la valeur attendue, notée $F_{MIN}$, est la plus petite des fréquences d'oscillation mesurées,
- le paramètre d'écart permis, noté TTT, est exprimé en pourcentage de la valeur attendue, et
- ledit au moins un paramètre de référence, noté $F_{REF}$, est une fréquence seuil calculée de la façon suivante :

$$F_{REF} = F_{MIN}.(1+TTT),$$

des défauts étant détectés dans lesdits vias TSV dès qu'une fréquence d'oscillation mesurée dépasse cette fréquence seuil.

De façon optionnelle également :

- la valeur attendue, notée $F_{MOY}$, est la moyenne des fréquences d'oscillation mesurées,
- le paramètre d'écart permis, noté TTT, est exprimé en pourcentage de la valeur attendue, et
- ledit au moins un paramètre de référence, noté $[F_{REF-INF}, F_{REF-SUP}]$, est constitué des bornes inférieure et supérieure d'un intervalle de fréquences calculé de la façon suivante :

$$F_{REF-INF} = F_{MOY}.(1-TTT) \text{ et } F_{REF-SUP} = F_{MOY}.(1+TTT),$$

des défauts étant détectés dans lesdits vias TSV dès qu'une fréquence d'oscillation mesurée est en dehors de cet intervalle.

L'invention a également pour objet un dispositif de détection automatique de défauts dans des vias TSV formés dans une couche de matériau semi-conducteur, pour une détection ayant lieu avant empilement de cette couche avec une pluralité d'autres couches de matériau semi-conducteur lors de la conception d'un circuit intégré sur puce à couches multiples, comportant :

- des moyens de mesure sur chacun desdits vias TSV d'au moins un paramètre issu d'une caractéristique électrique des vias TSV,
- des moyens de détection de défauts dans lesdits vias TSV par comparaison des paramètres mesurés avec au moins un paramètre de référence,

comportant en outre des moyens de calcul dudit au moins un paramètre de référence à partir des paramètres mesurés.

De façon avantageuse, ledit au moins un paramètre mesuré sur chacun des vias TSV comporte une valeur de fréquence d'oscillation issue d'une caractéristique capacitive des vias TSV.

De façon optionnelle, les moyens de mesure comportent un ensemble d'oscillateurs en anneau connectés à tous les vias TSV formés dans la couche de matériau semi-conducteur, chacun de ces oscillateurs en anneau étant connecté à au moins un via TSV.

De façon optionnelle également, les moyens de calcul comportent :

- un compteur d'un nombre de fronts montants d'un signal d'oscillation d'un oscillateur en anneau sélectionné séquentiellement pendant un temps de comptage prédéterminé et programmable, pour la fourniture séquentielle d'une valeur de fréquence d'oscillation,
- un calculateur d'au moins une valeur attendue de la fréquence d'oscillation à mesurer sur chacun desdits oscillateurs en anneau, cette valeur attendue étant considérée comme caractéristique d'un oscillateur en anneau connecté à au moins un via TSV sans défauts, et d'au moins une fréquence de référence par application d'un paramètre d'écart permis, prédéterminé et programmable, autour de cette valeur attendue.

L'invention a également pour objet un système de détection automatique de défauts dans des vias TSV, comportant :

- un dispositif de détection selon l'invention, et
- un module de contrôle d'un accès, depuis un testeur externe, au dispositif de détection selon la norme IEEE 1149.1 dite norme JTAG.

L'invention sera mieux comprise à l'aide de la description qui va suivre, donnée uniquement à titre d'exemple et faite en se référant aux dessins annexés dans lesquels :

- la figure 1 illustre schématiquement la structure générale d'un système comportant un dispositif de détection automatique de défauts selon un mode de réalisation possible de l'invention,
- la figure 2 représente une vue en coupe d'une couche d'un circuit intégré comprenant des vias TSV avec défauts,
- la figure 3 représente le schéma électrique de moyens de mesure du dispositif de détection de la figure 1, connectés aux vias TSV d'un circuit intégré,
- la figure 4 illustre en détail le schéma électrique d'un oscillateur en anneau des moyens de mesure de la figure 3,
- la figure 5 représente un schéma électrique des moyens de mesure alternatif à celui représenté sur la figure 3, selon un mode de réalisation préféré,
- la figure 6 illustre les étapes successives d'un procédé de détection mis en oeuvre par le dispositif de détection de la figure 1 à l'aide des moyens de mesure de la figure 3 ou de la figure 5.

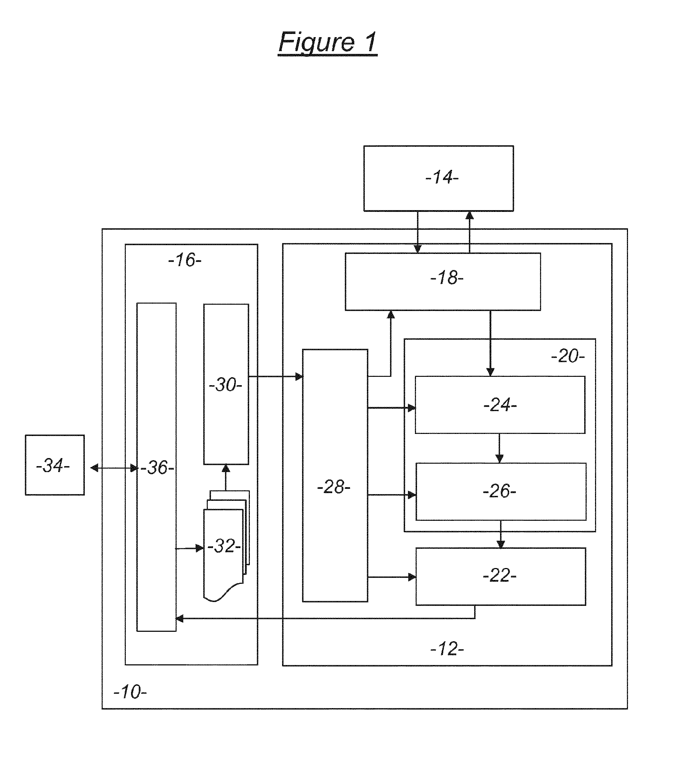

Le système 10 de détection automatique de défauts représenté schématiquement sur la figure 1 comporte un dispositif 12 de détection automatique de défauts dans des vias TSV 14 formés dans une couche de matériau semi-conducteur d'un circuit intégré sur puce à couches multiples. De façon optionnelle, ce système de détection 10 comporte un module 16 de contrôle d'un accès possible à partir d'un testeur externe 34, bien sûr extérieur au dispositif de détection 12, selon la norme IEEE 1149.1 dite norme JTAG (de l'anglais « Joint Test Action Group »).

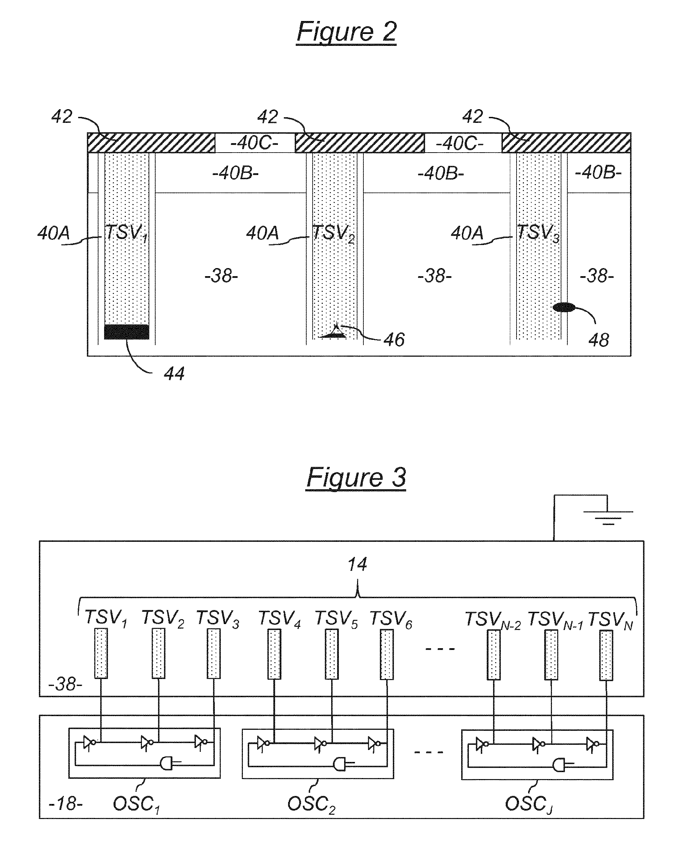

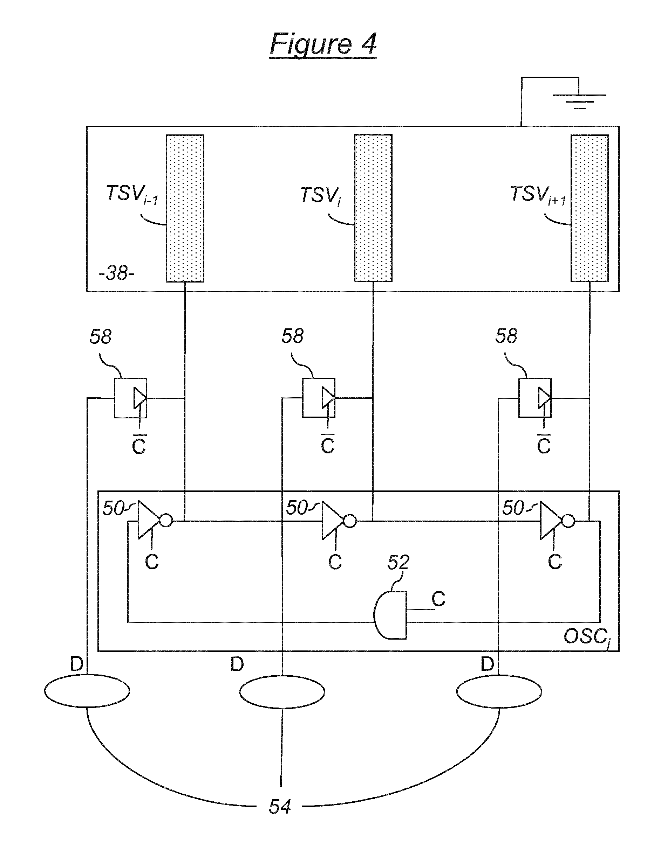

Le dispositif 12 de détection de défauts comporte des moyens 18 de mesure, sur chacun des vias TSV 14, de paramètres issus d'une caractéristique électrique des vias TSV 14. Ces moyens de mesure seront détaillés en référence aux figures 3, 4 et 5. Il comporte en outre des moyens 20 de calcul d'un ou de plusieurs paramètres de référence de façon relative à partir des paramètres mesurés et des moyens 22 de détection de défauts dans les vias TSV par comparaison des paramètres mesurés avec le ou les paramètres de référence calculés. Les moyens de calcul 20 comportent plus précisément un compteur 24 et un calculateur 26. Le fonctionnement du compteur 24, du calculateur 26 et des moyens de détection 22 sera détaillé en référence aux figures 4, 5 et 6.

Le dispositif 12 de détection de défauts comporte en outre une machine à états finis 28 permettant son démarrage et la transmission des résultats de la détection. Par ailleurs, cette machine à états finis 28 fournit des signaux de contrôle et des paramètres prédéterminés programmables nécessaires à la commande des moyens de mesure 18, des moyens de calcul 20 et des moyens de détection 22.

Le module de contrôle 16, qualifié de contrôleur JTAG, est doté d'un ou plusieurs registres JTAG 32 accessibles en lecture et en écriture par un testeur JTAG 34 extérieur au système 10 et au moyen de signaux répondant à la norme JTAG. Ce contrôleur JTAG 16 dispose d'un décodeur 30 d'instructions JTAG capable d'interpréter de telles instructions mémorisées dans son ou ses registres JTAG 32 et de générer des signaux d'instruction vers la machine à états finis 28. Il dispose également d'une interface 36 de réception et transmission de résultats d'une détection de défauts dans les vias TSV 14, cette interface 36 étant configurée pour recevoir ces résultats de la part des moyens de détection 22 et pour les transmettre vers le testeur JTAG externe 34.

La figure 2 donne un exemple de vias TSV avec défauts, tels qu'il peut s'en trouver parmi les vias TSV 14 de la figure 1. Plus précisément, elle illustre une vue en coupe d'une couche d'un circuit intégré sur puce à couches multiples comprenant trois vias $TSV_1$, $TSV_2$ et $TSV_3$, formés dans une couche de matériau semi-conducteur 38 avant amincissement et empilement de cette couche avec une pluralité d'autres couches de matériau semi-conducteur. Ces vias TSV sont entourés d'un matériau isolant 40A permettant d'isoler les vias TSV de la couche de matériau semi-conducteur 38. L'extrémité supérieure de chacun de ces vias TSV est en contact avec une piste métallique 42 permettant par exemple la connexion de ces vias $TSV_1$, $TSV_2$ et $TSV_3$ avec une ou plusieurs fonctions logiques de cette couche de matériau semi-conducteur 38. L'extrémité inférieure des vias $TSV_1$, $TSV_2$ et $TSV_3$ se trouve dans la couche de matériau semi-conducteur 38 et ne débouche pas vers l'extérieur puisque la couche de matériau semi-conducteur 38 est illustrée sur cette figure à un stade de fabrication de circuit intégré où elle n'est pas encore amincie. On notera par ailleurs qu'une couche de matériau isolant 40B peut s'étendre au niveau de l'extrémité supérieure des vias $TSV_1$, $TSV_2$ et $TSV_3$ entre la couche de matériau semi-conducteur 38 et la piste métallique 42. Du matériau isolant 40C peut également être inséré entre les conducteurs de la piste métallique 42. L'isolant 40A entourant les vias TSV, celui 40B séparant la couche de matériau semi-conducteur 38 de la piste métallique 42, et celui 40C s'étendant dans la piste métallique 42 entre ses conducteurs, peuvent être un même isolant.

La figure 2 illustre en outre trois types de défauts pouvant apparaître lors de la formation d'un via TSV au cours du procédé de fabrication d'un circuit intégré. Un remplissage insuffisant 44 du via $TSV_1$ ou la présence d'un microvide 46 dans le via $TSV_2$ provoquent une diminution de la capacité des vias $TSV_1$ et $TSV_2$ par rapport à la capacité d'un via TSV sans défauts. Des poussières 48 déposées autour du via $TSV_3$ lors du procédé de fabrication peuvent provoquer des courants de fuites à travers ce via.

La figure 3 représente le schéma électrique des moyens de mesure 18 selon un mode de réalisation possible de l'invention. Les moyens de mesure 18 sont directement connectés à chacun ($TSV_1$, $TSV_2$, ..., $TSV_N$) des N vias TSV 14 formés dans la couche de matériau semi-conducteur 38 d'un circuit intégré et permettent la mesure de paramètres issus d'une caractéristique électrique de ces vias TSV 14. Les vias TSV 14 sont en outre indirectement reliés à la masse par une connexion directe du matériau semi-conducteur 38 à cette masse. Ils ne sont ainsi pas flottants électriquement.

Selon ce mode de réalisation de l'invention, les moyens de mesure 18 comportent un ensemble {$OSC_1$, $OSC_2$, ..., $OSC_J$} d'oscillateurs en anneau, chacun connecté à au moins un via $TSV_i$ de l'ensemble des vias TSV 14. Plus précisément, dans l'exemple illustré sur la figure 3, chaque oscillateur en anneau est connecté à plusieurs vias TSV, par exemple trois : l'oscillateur en anneau $OSC_1$ est ainsi connecté aux vias $TSV_1$, $TSV_2$ et $TSV_3$, l'oscillateur en anneau $OSC_2$ est connecté aux vias $TSV_4$, $TSV_5$ et $TSV_6$, ... et l'oscillateur en anneau $OSC_J$ est connecté aux vias $TSV_{N-2}$, $TSV_{N-1}$ et $TSV_N$.

La machine à états finis 28 est conçue pour commander ces moyens de mesure 18 en sélectionnant et sollicitant séquentiellement chacun des oscillateurs en anneau de l'ensemble {$OSC_1$, $OSC_2$, ..., $OSC_J$}.

L'un quelconque des oscillateurs en anneau de la figure 3 est détaillé sur la figure 4. Cet oscillateur en anneau, noté $OSC_j$, est connecté à plusieurs vias TSV, par exemple trois vias notés $TSV_{i-1}$, $TSV_i$, $TSV_{i+1}$. Un tel oscillateur en anneau $OSC_j$ consiste en un nombre impair de portes logiques « inverseuses », dites inverseurs 50, connectées en anneau les unes aux autres générant un signal oscillatoire à la sortie de chaque porte logique caractérisé par une certaine fréquence d'oscillation.

Par ailleurs, dans l'exemple de l'oscillateur en anneau illustré sur la figure 4, une porte logique AND 52 recevant sur une entrée supplémentaire un signal de commande C est destinée à mettre en marche et arrêter l'oscillateur en anneau $OSC_j$.

Lorsque l'oscillateur en anneau $OSC_j$ se met à osciller, la valeur de la fréquence d'oscillation du signal d'oscillation varie avec le nombre de vias TSV connectés à l'oscillateur et avec les caractéristiques capacitives des vias TSV auxquels il est connecté.

Les inverseurs 50 de l'oscillateur en anneau $OSC_j$ sont placés avant et après chaque via $TSV_{i-1}$, $TSV_i$, $TSV_{i+1}$ permettant la charge de chaque via TSV sur le front montant du signal d'oscillation et la décharge sur le front descendant du signal d'oscillation. Les temps de charge et de décharge pour chacun des vias $TSV_{i-1}$, $TSV_i$, $TSV_{i+1}$ connectés à l'oscillateur en anneau $OSC_j$ varient en fonction de la valeur de la capacité de chaque via TSV. Ainsi, si la valeur de la capacité d'un via TSV diminue, les temps de charge et de décharge de ce via TSV diminuent provoquant une réduction de la durée de la période d'oscillation et en conséquence une augmentation de la fréquence de l'oscillateur en anneau $OSC_j$.

A titre d'exemple et comme déjà évoqué précédemment, un remplissage insuffisant 44 de l'un quelconque des vias $TSV_{i-1}$, $TSV_i$, $TSV_{i+1}$ provoque une diminution de la capacité de ce via TSV et la valeur de la fréquence d'oscillation $F_j$ de l'oscillateur en anneau $OSC_j$ connecté à ce via sera plus élevée que celle d'un oscillateur en anneau connecté à des vias TSV sans défauts.

Les défauts du conducteur dans les vias TSV peuvent ainsi être détectés en mesurant les valeurs des fréquences d'oscillation ($F_1$, $F_2$, ..., $F_J$) des oscillateurs en anneau $OSC_1$, $OSC_2$, ..., $OSC_J$ et en les comparant avec une fréquence de référence $F_{REF}$.

Pour rappel, la fonction des vias TSV 14 dans un circuit intégré à couches multiples est d'assurer la communication entre deux couches, l'une supérieure et l'autre inférieure, du circuit. Ainsi, des données D provenant d'une fonction logique 54 quelconque du circuit intégré à couches multiples transitent entre les différentes couches du circuit au travers des vias TSV 14, la fonction logique 54 étant elle aussi connectée aux vias TSV 14. Le système 10 de détection automatique de défauts est quant à lui ajouté au circuit intégré lors de sa conception, la finalité de ce système 10 étant de détecter automatiquement les défauts dans des vias TSV du circuit intégré pendant les étapes de test lors de la fabrication du circuit. Néanmoins, à la fin de la fabrication du circuit, le système 10 reste lui aussi intégré dans le circuit, mais il n'est plus actif et ne doit pas gêner la transmission des données D entre la fonction logique 54 et les vias TSV 14 lors de la mise en fonctionnement du circuit.

Il est donc nécessaire de distinguer deux modes de fonctionnement différents des vias TSV 14 : un mode fonctionnel, utilisé pour faire fonctionner le circuit intégré, dans lequel la connexion de la fonction logique 54 aux vias TSV 14 est activée pour que les données D traversent les vias TSV ; et un mode test, utilisé pour détecter des défauts dans les vias TSV, dans lequel la connexion des oscillateurs en anneau $OSC_1$, $OSC_2$, ..., $OSC_J$ aux vias TSV 14 est activée pour qu'ils oscillent.

Afin de bien isoler ces deux modes de fonctionnement l'un de l'autre, une solution possible bien connue de l'homme du métier consiste à utiliser des inverseurs avec des sorties à trois états. Ce type d'inverseur inclut un signal de commande qui lui permet de passer d'un état de sortie valide, la sortie prenant une valeur haute ou basse, à un état de sortie non valide ou état de haute impédance dans lequel la sortie de l'inverseur n'a aucune influence sur le reste du circuit. Avantageusement, le signal de commande qui alimente ces inverseurs à trois états de sortie est le signal de commande C destiné à mettre en marche et arrêter l'oscillateur en anneau $OSC_j$.

L'oscillateur en anneau $OSC_j$ est donc plus précisément doté d'inverseurs 50 avec des sorties à trois états, l'état de sortie valide/non valide de ces inverseurs 50 répondant au signal de commande C. D'un autre côté, des inverseurs 58 avec des sorties à trois états répondant au signal de commande C inversé ou C sont placés dans le chemin par lequel les données D transitent entre la fonction logique 54 et les vias $TSV_{i-1}$, $TSV_i$, $TSV_{i+1}$. De cette façon, en mode fonctionnel, le signal de commande C vaut 0 et la sortie des inverseurs 50 de l'oscillateur en anneau $OSC_j$ passe à l'état de haute impédance déconnectant l'oscillateur du reste du circuit. En même temps, les sorties des inverseurs 58 sont en état valide et les données D peuvent circuler au travers les vias $TSV_{i-1}$, $TSV_i$, $TSV_{i+1}$ entre les couches supérieure et inférieure du circuit. En mode test, le signal de commande C vaut 1, par conséquent les sorties des inverseurs 58 passent à l'état de haute impédance et les sorties des inverseurs 50 deviennent valides déclenchant l'oscillation de l'oscillateur en anneau $OSC_j$ et permettant le test des vias $TSV_{i-1}$, $TSV_i$, $TSV_{i+1}$.

Afin de mesurer la fréquence d'oscillation de l'oscillateur en anneau sélectionné par la machine à états finis 28, le compteur 24 des moyens de calcul 20 est conçu pour compter, pendant un temps de comptage $T_C$ prédéterminé et programmable, un nombre de fronts montants du signal d'oscillation de l'oscillateur en anneau sélectionné, par exemple $OSC_j$, et détermine ainsi sa fréquence d'oscillation $F_j$. Ce compteur 24 mesure ainsi la valeur d'une fréquence d'oscillation qui dépend de la valeur des capacités des vias TSV connectés à l'oscillateur en anneau $OSC_j$. La valeur de cette fréquence d'oscillation n'est pas constante et varie en fonction des temps de charge et décharge des vias TSV 14.

Lors du procédé de fabrication d'un circuit intégré, certains paramètres de fabrication, par exemple la température ou la tension d'alimentation, peuvent varier. Il a été montré que pour une même valeur de capacité des vias TSV ces variations affectent la valeur de la fréquence d'oscillation mesurée. Ainsi, d'un procédé de fabrication à un autre on peut avoir des valeurs de fréquences d'oscillation différentes pour une même valeur de capacité, ce qui montre qu'il n'est pas souhaitable d'avoir une référence absolue pour ces valeurs de fréquences. En revanche, les variations relatives des fréquences d'oscillation mesurées entre elles pour une même valeur de capacité sont insensibles aux variations des paramètres de fabrication, ce qui montre qu'il est avantageux d'avoir une référence relative pour ces valeurs de fréquences.

Finalement, la valeur de ces variations relatives de fréquences dépend de la variation de capacité des vias TSV et du nombre de vias TSV connectés à chaque oscillateur en anneau.

Il a été montré en outre, que plus le nombre de vias TSV connectés à un oscillateur en anneau est élevé, moins la variation relative de fréquence est importante par rapport à la variation de leurs capacités. Par conséquent, la meilleure précision de mesure des variations de fréquences est obtenue lorsqu'un seul via TSV est connecté à un oscillateur en anneau.

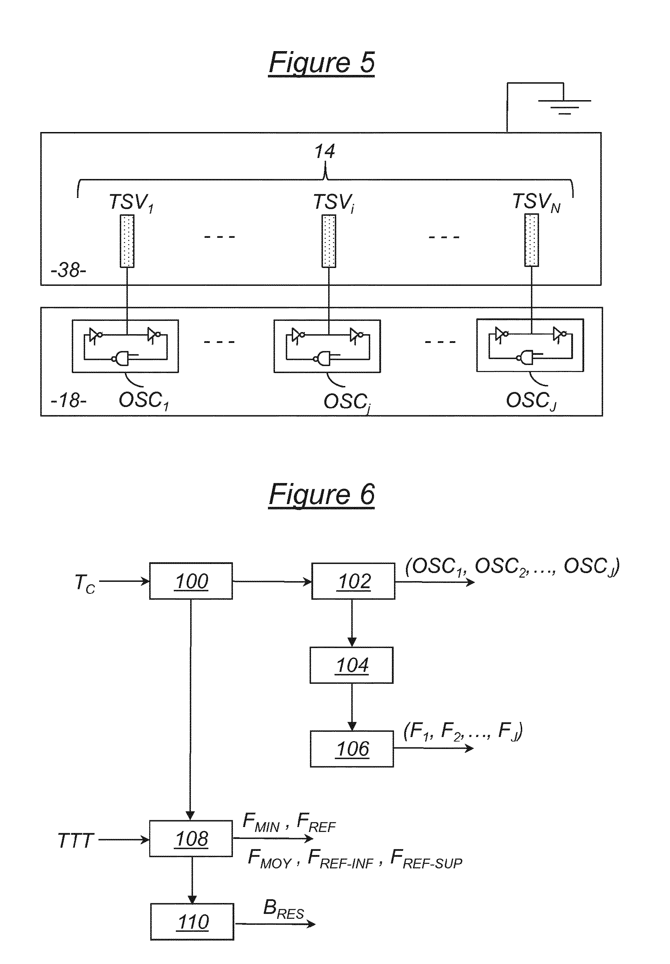

La figure 5 est une figure alternative à la figure 3 et illustre le schéma électrique des moyens 18 de mesure d'un mode de réalisation préféré où un seul via TSV est connecté à chaque oscillateur en anneau.

Plus précisément, chaque oscillateur en anneau de l'ensemble {$OSC_1$, $OSC_2$, ..., $OSC_J$} d'oscillateurs en anneau est connecté à un unique via TSV de l'ensemble {$TSV_1$, $TSV_2$, ..., $TSV_N$} des vias TSV 14. Ainsi, l'oscillateur en anneau $OSC_1$ est connecté au via $TSV_1$, l'oscillateur en anneau $OSC_2$ est connecté au via $TSV_2$, ... et l'oscillateur en anneau $OSC_J$ est connecté au via $TSV_N$, le nombre J d'oscillateurs en anneau étant, dans ce cas, le même que le nombre N de vias TSV, N=J.

Chacun de ces oscillateurs en anneau comporte deux inverseurs placés avant et après le via TSV auquel il est connecté, permettant la charge et la décharge du via TSV, et une porte logique NAND commandée par le signal C, destinée à mettre en marche et arrêter l'oscillateur.

Le calculateur 26 des moyens de calcul 20 est conçu pour calculer une valeur attendue $F_{TH}$ de la fréquence d'oscillation d'un oscillateur en anneau à partir des valeurs des fréquences d'oscillation ($F_1$, $F_2$, ..., $F_J$) effectivement mesurées pour chacun des oscillateurs en anneau $OSC_1$, $OSC_2$, ..., $OSC_J$, toutes ces valeurs provenant du compteur 24. Cette valeur attendue $F_{TH}$ est considérée comme caractéristique d'un oscillateur en anneau connecté à un ou plusieurs vias TSV sans défauts. En outre, le calculateur 26 fournit au moins une fréquence de référence $F_{REF}$ par application d'un paramètre TTT d'écart permis, prédéterminé et programmable, autour de cette valeur attendue $F_{TH}$. Le paramètre TTT est par exemple exprimé en pourcentage de la valeur attendue et correspond ainsi à un pourcentage permis de variation autour de la valeur attendue $F_{TH}$ de la fréquence d'oscillation d'un oscillateur en anneau comportant des vias TSV sans défauts. Cette valeur du paramètre TTT dépend des variations admises des capacités des vias TSV 14 et du nombre de vias TSV connectés à chaque oscillateur en anneau.

Les moyens de détection 22 détectent si dans le circuit il y a au moins un via TSV avec défaut par comparaison des valeurs des fréquences d'oscillation mesurées $F_1$, $F_2$, ... $F_J$ avec ladite au moins une fréquence de référence $F_{REF}$.

Le procédé de détection illustré sur la figure 6 et mis en oeuvre par le dispositif 12 de la figure 1 comporte une première étape 100 de mesure, sur chacun des vias TSV 14, d'au moins un paramètre issu d'une caractéristique électrique des vias TSV. Plus précisément, dans l'exemple des moyens de mesure 18 des figures 3, 4 et 5, le paramètre mesuré sur chacun des vias TSV est une valeur de fréquence d'oscillation, dépendante d'une caractéristique capacitive de ce via TSV, de l'oscillateur en anneau connecté à ce via TSV.

Plus précisément, lors d'une première sous étape 102 de la première étape 100, les moyens de mesure 18 comportant l'ensemble {$OSC_1$, $OSC_2$, ..., $OSC_J$} d'oscillateurs en anneau sont connectés à tous les vias TSV formés dans la couche de matériau semi-conducteur 38, chaque oscillateur en anneau étant connecté à au moins un via TSV (un via dans l'exemple de la figure 5 ou trois vias dans celui de la figure 3). La commande C permet de réaliser cette connexion en mettant en marche les oscillateurs en anneau tout en isolant les chemins fonctionnels du circuit.

Lors d'une deuxième sous étape 104 de la première étape 100, la machine à états finis 28 sélectionne de façon séquentielle chacun des oscillateurs en anneau $OSC_1$, $OSC_2$, ..., $OSC_J$ des moyens de mesure 18.

Au cours d'une troisième sous étape 106 de la première étape 100, le compteur 24 des moyens de calcul 20 mesure séquentiellement la fréquence d'oscillation de chaque oscillateur en anneau sélectionné. Ainsi, après avoir reçu préalablement des moyens de mesure 18 le signal d'oscillation de l'oscillateur en anneau sélectionné, le compteur 24 effectue le comptage d'un nombre de fronts montants de ce signal d'oscillation pendant le temps de comptage $T_C$ prédéterminé et programmable fourni préalablement au compteur 24 par la machine à états finis 28. Ensuite, ce compteur 24 fournit séquentiellement au calculateur 26 les valeurs de fréquence d'oscillation de chaque oscillateur en anneau sélectionné.

Le temps de comptage $T_C$ est choisi de manière à éviter la saturation du compteur 24 notamment pour une fréquence maximale d'oscillation d'un oscillateur en anneau. A titre d'exemple, si pour un oscillateur en anneau ne chargeant aucun TSV la fréquence maximale d'oscillation ne dépasse pas la valeur de 2 Ghz et la dimension du compteur 24 est fixée à 12 bit, la valeur maximale du temps de comptage sera de 2 µs.

Au cours d'une deuxième étape 108, le calculateur 26 des moyens de calcul 20 reçoit séquentiellement du compteur 24 les valeurs $F_1$, $F_2$, ..., $F_J$ des fréquences d'oscillation mesurées correspondant aux différents oscillateurs en anneau $OSC_1$, $OSC_2$, ..., $OSC_J$ des moyens de mesure 18 et calcule, à partir de ces fréquences, la valeur attendue $F_{TH}$ de la fréquence d'oscillation d'un oscillateur en anneau connecté à un ou plusieurs vias TSV sans défauts et au moins une fréquence de référence $F_{REF}$ par application du paramètre TTT d'écart permis, prédéterminé et programmable, autour de cette valeur attendue.

Selon un premier mode de réalisation possible, la valeur attendue $F_{TH}$ de la fréquence d'un oscillateur en anneau connecté à un ou plusieurs vias TSV sans défauts, notée $F_{MIN}$, est la plus petite des fréquences d'oscillation mesurées. Dans ce cas, la fréquence de référence $F_{REF}$, est une fréquence seuil calculée par addition à la fréquence attendue $F_{MIN}$, d'un écart permis de fréquence, cet écart de fréquence étant lui-même le produit du paramètre d'écart permis TTT défini précédemment avec la fréquence attendue $F_{MIN}$, selon l'expression : $F_{REF} = F_{MIN}*(1+TTT)$.

D'une façon générale, la valeur de la fréquence minimale $F_{MIN}$ est associée aux vias TSV ayant la plus grande capacité et donc aux vias TSV formés sans défauts. Par conséquent, la fréquence de référence $F_{REF}$ correspond à des vias TSV ayant une plus petite capacité et représente l'écart permis au-dessus de la fréquence attendue $F_{MIN}$ caractéristique d'un oscillateur connecté à des vias TSV sans défauts. Ainsi, dès qu'une fréquence d'oscillation mesurée dépasse cette fréquence seuil $F_{REF}$, il peut être considéré qu'elle correspond à un ou des vias TSV formés avec défauts.

Selon un second mode de réalisation possible, la valeur attendue $F_{TH}$ de la fréquence d'un oscillateur en anneau connecté à un ou plusieurs vias TSV sans défauts, notée $F_{MOY}$, est la moyenne des fréquences d'oscillation mesurées. Dans ce cas, les deux fréquences de référence, notées [$F_{REF-INF}$, $F_{REF-SUP}$], sont constituées des bornes inférieure et supérieure d'un intervalle de fréquences calculées respectivement en tant que soustraction et addition à la fréquence attendue $F_{MOY}$ d'un écart permis de fréquence, cet écart de fréquence étant lui-même le produit du paramètre d'écart permis TTT avec la fréquence attendue $F_{MOY}$, selon l'expression : $F_{REF-INF} = F_{MOY}*(1-TTT)$ et $F_{REF-SUP} = F_{MOY}*(1+TTT)$.

Lors d'une troisième étape 110, les défauts dans les vias TSV sont détectés en fonction d'une comparaison des paramètres mesurés avec la ou les fréquences de référence. Le résultat $B_{RES}$ de la comparaison est généré sur 1 bit, par exemple de valeur « 0 » en cas de détection de défaut et de valeur « 1 » si aucun défaut n'est détecté.

Ainsi, dans le mode de réalisation où la valeur attendue $F_{TH}$ correspond à la plus petite $F_{MIN}$ des fréquences d'oscillation mesurées, les moyens de détection 22, après avoir reçu du calculateur 26 la valeur de la fréquence de référence $F_{REF} = F_{MIN}*(1+TTT)$, détectent des défauts dans les vias TSV dès que l'une des fréquences d'oscillation mesurées dépasse cette fréquence seuil $F_{REF}$.

Dans le mode de réalisation où la valeur attendue $F_{TH}$ correspond à la moyenne $F_{MOY}$ des fréquences d'oscillation mesurées, les moyens de détection 22, après avoir reçu du calculateur 26 les valeurs des fréquences de référence $F_{REF-INF} = F_{MOY}*(1-TTT)$ et $F_{REF-SUP} = F_{MOY}*(1+TTT)$ définissant l'intervalle [$F_{REF-INF}$, $F_{REF-SUP}$], détectent des défauts dans les vias TSV dès que l'une des fréquences d'oscillation mesurées est en dehors de cet intervalle.

Dans le cas où un ou plusieurs défauts sont détectés, c'est-à-dire lorsque $B_{RES} = 0$, il est important de pouvoir localiser et réparer les vias TSV avec défauts. Pour répondre à ce besoin, deux instructions dites de diagnostic et de mise au point sont ajoutées aux instructions JTAG. L'instruction de diagnostic permet de calculer le nombre d'oscillateurs en anneau connectés à au moins un via TSV avec défaut et l'instruction de mise au point permet d'effectuer le test d'un oscillateur en anneau spécifique et donc d'identifier les oscillateurs en anneau connectés à au moins un via TSV avec défaut ou d'identifier même les vias TSV avec défaut lorsque chaque oscillateur en anneau est connecté à un seul via TSV. Ces instructions sont décodées par le décodeur 30 d'instructions JTAG qui interprète et génère des instructions vers la machine à états finis 28.

Les paramètres nécessaires à la génération de signaux d'instruction vers la machine à états finis 28 comme le temps de comptage $T_C$, le paramètre d'écart permis TTT, l'identification de l'oscillateur à tester, le choix de la valeur attendue $F_{MIN}$ ou $F_{MOY}$, ..., sont programmables sur les registres 32 JTAG par le testeur JTAG 34 extérieur au système de détection 10.

La table ci-dessous illustre un exemple possible de distribution de ces paramètres sur plusieurs champs d'un registre JTAG 32, ce registre comportant 32 bits :

| 31 ... 26 | | | | | 25 ... 18 | 17 | 16 | 15 ... 8 | 7...4 | 3...0 |
|---|---|---|---|---|---|---|---|---|---|---|
| | | | | | 70 | 68 | 66 | 64 | 62 | 60 |

La première ligne de la table indique les bits du registre JTAG 32 assignés à chaque champ. Les 4 premiers bits, du bit 0 au bit 3 du registre JTAG 32, contiennent un premier champ 60 comportant des codes d'identification des différentes instructions JTAG. Le deuxième champ 62, du bit 4 au bit 7, contient la valeur du paramètre TTT d'écart permis. Le troisième champ 64, du bit 8 au bit 15, contient un identifiant d'un oscillateur en anneau sélectionné pour l'instruction de mise au point. Le quatrième champ 66 contient un bit indiquant une horloge sur laquelle le temps de comptage va être mesuré. Le cinquième champ 68 contient un bit qui permet de sélectionner la valeur attendue $F_{MIN}$ ou $F_{MOY}$ d'une des deux variantes de réalisation précédemment exposées. Le sixième champ 70 contient la valeur du temps de comptage $T_C$ sur 8 bits. Le reste des bits de ce registre, du bit 26 au bit 31, n'est pas utilisé ou est utilisé pour d'autres fonctions optionnelles.

Dans le premier exemple de réalisation décrit ci-dessus, les moyens de mesure 12 comportent des oscillateurs en anneau 18 et le ou les paramètre de référence sont calculés de façon relative à partir des fréquences d'oscillation de ces oscillateurs en anneau.

Bien entendu, des variantes de réalisation des moyens de mesure 12 peuvent être envisagées, les paramètres de référence étant toujours calculés à partir des paramètres mesurés.

Dans un deuxième exemple de réalisation de l'invention, ces moyens de mesure pourraient très bien comporter une architecture à base d'amplificateurs de détection comme celle décrite dans l'article précité de Chen et al. La machine à états finis 28 permettrait dans ce cas la sélection séquentielle des amplificateurs de détection et le compteur 24 compterait le nombre de cycles d'horloge d'une horloge de référence pendant le temps de décharge d'un via TSV. Dans cette variante de réalisation, contrairement au mode de réalisation précédent, le temps de comptage $T_C$ est variable puisqu'il dépend du temps de décharge des vias TSV. En outre, la durée de ce temps de décharge est très courte, de l'ordre de 0,5 ns à 3 ns et ne permet pas de détecter un nombre suffisant de cycles d'horloge pour pouvoir détecter les variations de capacité. Face à ce problème, une solution possible est l'étalement du temps de comptage $T_C$.

Il apparaît clairement qu'un dispositif et qu'un procédé de détection tel que ceux décrits précédemment permettent de détecter automatiquement les défauts dans des vias TSV formés dans une couche de matériau semi-conducteur sans que la détection des défauts ne soit altérée par d'éventuelles variations des valeurs des caractéristiques électriques des vias TSV et des transistors lors du procédé de fabrication du circuit. En proposant l'utilisation de paramètres de référence calculés de façon relative à partir des paramètres mesurés, la précision de la détection de défauts est ainsi améliorée.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué. Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

**Revendications**

1. Procédé de détection automatique de défauts dans des vias TSV (14) formés dans une couche de matériau semi-conducteur (38), cette détection ayant lieu avant empilement de cette couche avec une pluralité d'autres couches de matériau semi-conducteur lors de la conception d'un circuit intégré sur puce à couches multiples, comportant :

- la mesure (100) sur chacun desdits vias TSV (14) d'au moins un paramètre ($F_1$, $F_2$, ..., $F_J$) issu d'une caractéristique électrique des vias TSV (14),
- la détection (110) de défauts dans lesdits vias TSV (14) en fonction d'une comparaison des paramètres mesurés ($F_1$, $F_2$, ..., $F_J$) avec au moins un paramètre de référence ($F_{REF}$ ; $F_{REF-INF}$, $F_{REF-SUP}$),

- le calcul (108) dudit au moins un paramètre de référence ($F_{REF}$ ; $F_{REF-INF}$, $F_{REF-SUP}$) à partir des paramètres mesurés ($F_1$, $F_2$, ..., $F_J$),

**caractérisé en ce que** ledit au moins un paramètre ($F_1$, $F_2$, ..., $F_J$) mesuré sur chacun des vias TSV (14) comporte une valeur de fréquence d'oscillation issue d'une caractéristique capacitive des vias TSV (14).

2. Procédé de détection automatique de défauts dans des vias TSV (14) selon la revendication 1, dans lequel le calcul (108) dudit au moins un paramètre de référence ($F_{REF}$ , $F_{REF-INF}$, $F_{REF-SUP}$) comporte :

- la détermination, à partir des paramètres mesurés ($F_1$, $F_2$, ..., $F_J$), d'une valeur attendue ($F_{TH}$) du paramètre à mesurer sur chacun desdits vias TSV (14), cette valeur attendue ($F_{TH}$) étant considérée comme caractéristique d'un via TSV sans défaut, et
- le calcul dudit au moins un paramètre de référence ($F_{REF}$ ; $F_{REF-INF}$, $F_{REF-SUP}$) par application d'un paramètre d'écart permis (TTT), prédéterminé et programmable, autour de cette valeur attendue ($F_{TH}$).

3. Procédé de détection automatique de défauts dans des vias TSV (14) selon la revendication 2, dans lequel la mesure (100) sur chacun desdits vias TSV (14) d'une valeur de fréquence d'oscillation issue d'une caractéristique capacitive des vias TSV (14) comporte les étapes suivantes:

- connexion (102) d'un ensemble d'oscillateurs en anneau ($OSC_1$, $OSC_2$, ..., $OSC_J$) à tous les vias TSV (14) formés dans la couche de matériau semi-conducteur (38), chaque oscillateur en anneau ($OSC_j$) étant connecté à au moins un via TSV ($TSV_{i-1}$, $TSV_i$, $TSV_{i+1}$ ; $TSV_i$),
- sélection séquentielle (104) de chacun desdits oscillateurs en anneau ($OSC_1$, $OSC_2$, ..., $OSC_J$),
- mesure séquentielle (106) d'une fréquence d'oscillation ($F_1$, $F_2$, ..., $F_J$) de chaque oscillateur en anneau sélectionné ($OSC_1$, $OSC_2$, ..., $OSC_J$).

4. Procédé de détection automatique de défauts dans des vias TSV (14) selon les revendications 2 et 3, dans lequel :

- la valeur attendue ($F_{TH}$), notée $F_{MIN}$, est la plus petite des fréquences d'oscillation mesurées ($F_1$, $F_2$, ..., $F_J$),
- le paramètre d'écart permis (TTT), noté TTT, est exprimé en pourcentage de la valeur attendue ($F_{TH}$), et
- ledit au moins un paramètre de référence ($F_{REF}$ ; $F_{REF-INF}$, $F_{REF-SUP}$), noté $F_{REF}$, est une fréquence seuil calculée de la façon suivante :

$$F_{REF} = F_{MIN}.(1+TTT),$$

des défauts étant détectés dans lesdits vias TSV (14) dès qu'une fréquence d'oscillation mesurée dépasse cette fréquence seuil.

5. Procédé de détection automatique de défauts dans des vias TSV (14) selon les revendications 2 et 3, dans lequel :

- la valeur attendue ($F_{TH}$), notée $F_{MOY}$, est la moyenne des fréquences d'oscillation mesurées ($F_1$, $F_2$, ..., $F_J$),
- le paramètre d'écart permis (TTT), noté TTT, est exprimé en pourcentage de la valeur attendue ($F_{TH}$), et
- ledit au moins un paramètre de référence ($F_{REF}$ ; $F_{REF-INF}$, $F_{REF-SUP}$), noté [$F_{REF-INF}$, $F_{REF-SUP}$], est constitué des bornes inférieure et supérieure d'un intervalle de fréquences calculé de la façon suivante :

$$F_{REF-INF} = F_{MOY}.(1-TTT) \text{ et } F_{REF-SUP} = F_{MOY}.(1+TTT),$$

des défauts étant détectés dans lesdits vias TSV (14) dès qu'une fréquence d'oscillation mesurée est en dehors de cet intervalle.

6. Dispositif (12) de détection automatique de défauts dans des vias TSV (14) formés dans une couche de matériau semi-conducteur (38), pour une détection ayant lieu avant empilement de cette couche avec une pluralité d'autres couches de matériau semi-conducteur lors de la conception d'un circuit intégré sur puce à couches multiples, comportant :

- des moyens (18) de mesure sur chacun desdits vias TSV (14) d'au moins un paramètre ($F_1$, $F_2$, ..., $F_J$) issu d'une caractéristique électrique des vias TSV (14),
- des moyens (22) de détection de défauts dans lesdits vias TSV (14) par comparaison des paramètres mesurés ($F_1$, $F_2$, ..., $F_J$) avec au moins un paramètre de référence ($F_{REF}$ ; $F_{REF-INF}$, $F_{REF-SUP}$),
- des moyens (20) de calcul dudit au moins un paramètre de référence ($F_{REF}$ ; $F_{REF-INF}$, $F_{REF-SUP}$) à partir des paramètres mesurés ($F_1$, $F_2$, ..., $F_J$),

**caractérisé en ce que** ledit au moins un paramètre ($F_1$, $F_2$, ..., $F_J$) mesuré sur chacun des vias TSV (14) comporte une valeur de fréquence d'oscillation issue d'une caractéristique capacitive des vias TSV (14).

7. Dispositif (12) de détection automatique de défauts dans des vias TSV selon la revendication 6, dans lequel les moyens de mesure (18) comportent un ensemble d'oscillateurs en anneau ($OSC_1$, $OSC_2$, ..., $OSC_J$) connectés à tous les vias TSV (14) formés dans la couche de matériau semi-conducteur (38), chacun de ces oscillateurs en anneau étant ($OSC_1$, $OSC_2$, ..., $OSC_J$) connecté à au moins un via TSV (14).

8. Dispositif (12) de détection automatique de défauts dans des vias TSV (14) selon la revendication 7, dans lequel les moyens de calcul (20) comportent :

- un compteur (24) d'un nombre de fronts montants d'un signal d'oscillation d'un oscillateur en anneau sélectionné séquentiellement pendant un temps ($T_C$) de comptage prédéterminé et programmable, pour la fourniture séquentielle d'une valeur de fréquence d'oscillation,
- un calculateur (26) d'au moins une valeur attendue ($F_{TH}$) de la fréquence d'oscillation à mesurer sur chacun desdits oscillateurs en anneau, cette valeur attendue ($F_{TH}$) étant considérée comme caractéristique d'un oscillateur en anneau connecté à au moins un via TSV sans défauts, et d'au moins une fréquence de référence ($F_{REF}$ ; $F_{REF-INF}$, $F_{REF-SUP}$) par application d'un paramètre d'écart permis (TTT), prédéterminé et programmable, autour de cette valeur attendue ($F_{TH}$).

9. Système (10) de détection automatique de défauts dans des vias TSV (14), comportant :

- un dispositif de détection (12) selon l'une quelconque des revendications 6 à 8, et
- un module (16) de contrôle d'un accès, depuis un testeur externe (34), au dispositif de détection (12) selon la norme IEEE 1149.1 dite norme JTAG.

# *Figure 1*

## Figure 2

## Figure 3

# Figure 4

## Figure 5

## Figure 6

Europäisches
Patentamt

European
Patent Office

Office européen
des brevets

**RAPPORT DE RECHERCHE EUROPEENNE**

Numéro de la demande

EP 14 15 9954

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | JUN SO PAK ET AL: "Optimized inverter design of ring oscillator based wafer-level TSV connectivity test (RO-TSV-CT)", ELECTRICAL DESIGN OF ADVANCED PACKAGING AND SYSTEMS SYMPOSIUM (EDAPS), 2012 IEEE, IEEE, 9 décembre 2012 (2012-12-09), pages 239-242, XP032337156, DOI: 10.1109/EDAPS.2012.6469395 ISBN: 978-1-4673-1444-2 * Parties I., II., III.B., III.D.; figures 1-4 * | 1-9 | INV. H01L21/66 |
| Y | YU-HSIANG LIN ET AL: "A unified method for parametric fault characterization of post-bond TSVs", TEST CONFERENCE (ITC), 2012 IEEE INTERNATIONAL, IEEE, 5 novembre 2012 (2012-11-05), pages 1-10, XP032297715, DOI: 10.1109/TEST.2012.6401566 ISBN: 978-1-4673-1594-4 * Parties I., II.C., III.; figure 3 * | 1-9 | |
| | -/-- | | **DOMAINES TECHNIQUES RECHERCHES (IPC)** H01L G01R |

Le présent rapport a été établi pour toutes les revendications

| Lieu de la recherche | Date d'achèvement de la recherche | Examinateur |
|---|---|---|
| Munich | 13 juin 2014 | Seck, Martin |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 14 15 9954

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (IPC) |
| A,D | YI LOU ET AL: "Comparing Through-Silicon-Via (TSV) Void/Pinhole Defect Self-Test Methods", JOURNAL OF ELECTRONIC TESTING ; THEORY AND APPLICATIONS, KLUWER ACADEMIC PUBLISHERS, BO, vol. 28, no. 1, 3 novembre 2011 (2011-11-03), pages 27-38, XP035018608, ISSN: 1573-0727, DOI: 10.1007/S10836-011-5261-4 * Parties 2.1 et 4; figures 2,3 * | 1,4,6 | |
| A | WO 2012/128760 A1 (VERIGY PTE LTD SINGAPORE [SG]; KHOCHE AJAY [US]; VOLKERINK ERIK [US]) 27 septembre 2012 (2012-09-27) * alinéas [0005], [0037], [0059]; figures 4,18 * | 1,6 | |
| X,P | YASSINE FKIH ET AL: "A 3D IC BIST for pre-bond test of TSVs using ring oscillators", NEW CIRCUITS AND SYSTEMS CONFERENCE (NEWCAS), 2013 IEEE 11TH INTERNATIONAL, IEEE, 16 juin 2013 (2013-06-16), pages 1-4, XP032447562, DOI: 10.1109/NEWCAS.2013.6573611 ISBN: 978-1-4799-0618-5 * figures 2,5,6 * | 1-9 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 13 juin 2014 | Seck, Martin |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........
& : membre de la même famille, document correspondant

EPO FORM 1503 03.82 (P04C02)

**EP 2 779 221 A1**

## ANNEXE AU RAPPORT DE RECHERCHE EUROPEENNE
## RELATIF A LA DEMANDE DE BREVET EUROPEEN NO.

EP 14 15 9954

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

13-06-2014

| Document brevet cité au rapport de recherche | Date de publication | Membre(s) de la famille de brevet(s) | Date de publication |
|---|---|---|---|
| WO 2012128760  A1 | 27-09-2012 | US  2014002121 A1<br>WO  2012128760 A1 | 02-01-2014<br>27-09-2012 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **CHEN et al.** On-chip TSV testing for 3D IC before bonding using sense amplification. *Asian Test Symposium,* 2009, 450-455

- **LOU et al.** Comparing Through-Silicon-Via (TSV) void/pinhole defect self-test methods. *Journal of Electronic Testing,* Novembre 2011, vol. 28 (1), 27-38